(19) Europäisches Patentamt
European Patent Office
Office européen des brevets

(11) **EP 4 432 613 A1**

(12) **EUROPEAN PATENT APPLICATION**

(43) Date of publication:
**18.09.2024** Bulletin 2024/38

(21) Application number: **23162097.2**

(22) Date of filing: **15.03.2023**

(51) International Patent Classification (IPC):
*H04L 25/49* (2006.01)  *H04L 25/02* (2006.01)
*H03K 9/08* (2006.01)  *H03K 9/04* (2006.01)

(52) Cooperative Patent Classification (CPC):
**H04L 25/4904; H04L 25/0292**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **NXP B.V.**
**5656 AG Eindhoven (NL)**

(72) Inventor: **VAN DER CAMMEN, Peter**
**2628 Delft (NL)**

(74) Representative: **Schmütz, Christian Klaus
Johannes
NXP Semiconductors Germany GmbH
Intellectual Property Group
Beiersdorfstr. 12
22529 Hamburg (DE)**

(54) **SWITCHED CAPACITOR FILTER CIRCUIT**

(57)     This disclosure relates to a switched capacitor filter circuit for a Manchester code demodulator. An example embodiment includes a filter circuit (800) comprising: an input connection (601); a plurality of output connections (602a-f); and a plurality of switched capacitor circuits (603a-f), each switched capacitor circuit (603a-f) comprising: a first sampling switch (604a-f) connected between the input connection (601) and a first node (605a-f); a sampling capacitor (606a-f) connected between the first node (605a-f) and a common connection (407); and a first filter switch (608a-f) connected between the first node (605a-f) and a second node (611$_1$), the circuit (800) further comprising a first filter capacitor (612$_1$) connected between the second node (611$_1$) of each of the switched capacitor circuits (603a-f) and the common connection (407).

Fig. 8

EP 4 432 613 A1

**Description**

Field

This disclosure relates to a switched capacitor filter circuit for a Manchester code demodulator.

Background

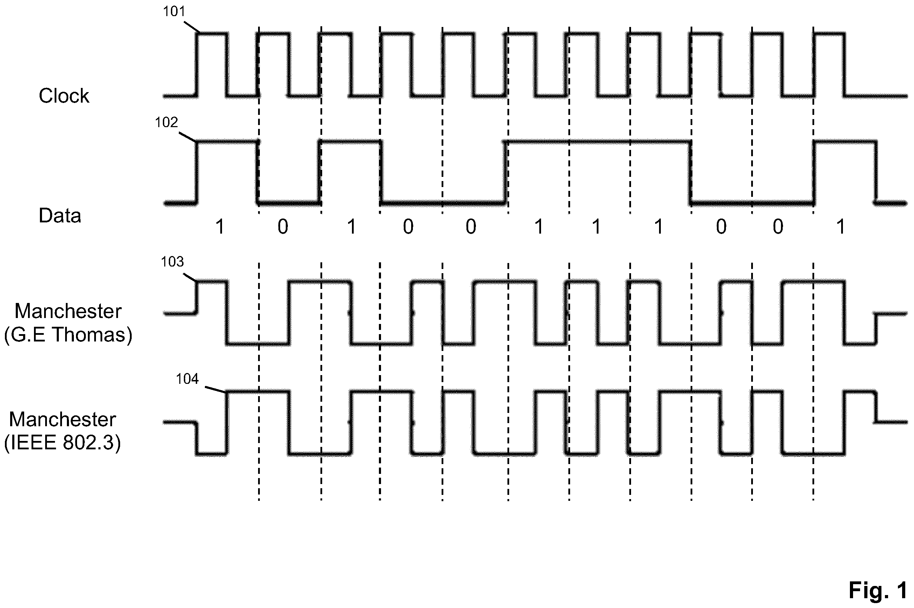

Manchester code is a binary code created via binary phase-shift keying (BPSK). The signal associated with a Manchester encoded bit stream is a self-clocking signal with no DC component. Example first and second Manchester encoded signals 103, 104 are shown in Figure 1, along with a clock signal 101 and data bit stream 102 from which the encoded signals 103, 104 are derived. The first and second Manchester encoded signals 103, 104 are encoded according to the G.E Thomas standard and the IEEE 802.3 standard respectively. In each case, a transition at the middle of a bit period indicates the data bit being transmitted, with the direction of the transition indicating whether the bit is one or zero. According to the G.E. Thomas standard, a 1 value is indicated by a falling transition (i.e. high to low) and a 0 value is indicated by a rising transition (low to high). The IEEE 802.3 standard is the reverse of this.

A Manchester encoded signal can be demodulated using a matched filter. A matched filter is created by correlating a known delayed signal, or template, with an unknown signal to detect the presence of the template in the unknown signal. This allows the presence of the known signal to be detected in a noisy environment. This is equivalent to convolving the unknown signal with a conjugated time-reversed version of the template. Creating a circuit with the properties of a matched filter typically involves the use of active components to delay the input signal and subtract the delayed input signal. These active components are connected directly in the signal path, causing signal distortion and requiring a higher supply current.

Summary

According to a first aspect there is provided a filter circuit comprising:

an input connection;
a plurality of output connections; and
a plurality of switched capacitor circuits, each switched capacitor circuit comprising:

a first sampling switch connected between the input connection and a first node;
a sampling capacitor connected between the first node and a common connection; and
a first filter switch connected between the first node and a second node,

the circuit further comprising a first filter capacitor connected between the second node of each of the switched capacitor circuits and the common connection.

Each switched capacitor circuit may further comprise a second filter switch connected between the first node and a third node, the circuit further comprising a second filter capacitor connected between the third node and the common connection. Each switched capacitor circuit may further comprise a third filter switch connected between the first node and a fourth node, the circuit further comprising a third filter capacitor connected between the fourth node and the common connection.

Where the input connection is a first input connection, the circuit may further comprise a second input connection, each switched capacitor circuit comprising:

a second sampling switch connected between the second input connection and a fifth node; and
a third sampling switch connected between the fifth node and the common connection, the first sampling capacitor connected between the first node and the fifth node for receiving a differential input signal via the first and second sampling switches.

The filter circuit may further comprise a controller configured to provide switching signals to each of the sampling switches and filter switches at a switching frequency.

According to a second aspect there is provided a Manchester code demodulator comprising:

a filter module configured to receive an input coded signal and provide a filtered signal;
a delay module configured to receive the filtered signal from the filter module and output a delayed signal;

a subtractor module configured to receive the filtered signal from the filter module and the delayed signal from the delay module and to provide an output decoded signal by subtracting the delayed signal from the filtered signal, wherein the filter module comprises a plurality of filter circuits according to the first aspect, the input connection of each filter circuit configured to receive the input coded signal.

The Manchester code demodulator may further comprise a controller configured to provide switching signals to each of the sampling switches and filter switches of the plurality of filter circuits at a switching frequency.

The controller may be configured to provide a switching signal to the first sampling switch of one of the switched capacitor circuits of each of the filter circuits to connect the input signal to the sampling capacitor during a switching cycle. The controller may be configured, in a subsequent switching cycle, to provide a switching signal to the first sampling switch of another one of the switched capacitor circuits.

The filter module may be configured, under control of the switching signals provided by the controller, to provide in-phase, I, and quadrature, Q, output signals to the delay module. The I and Q output signals may be differential signals, i.e. comprising positive and negative components.

The filter module may be configured, under control of the switching signals provided by the controller, to provide current and delayed, I and Q output signals to the subtractor module. The current and delayed I and Q control signals may also be differential signals.

The delay module may be configured to generate current and delayed swap signals from signs of the current I and Q signals.

The subtractor module may comprise a plurality of swap modules arranged to swap I and Q signals output from the filter module under control of the current and delayed swap signals generated by the delay module.

The subtractor module comprises a combining function arranged to combine I and Q signals output by the swap modules to provide a combined output signal.

The subtractor module may comprise a comparator arranged to receive the combined output signal from the combining function and to provide the output decoded signal.

These and other aspects of the invention will be apparent from, and elucidated with reference to, the embodiments described hereinafter.

Brief description of Drawings

Embodiments will be described, by way of example only, with reference to the drawings, in which:

Figure 1 is a schematic plot of a series of signals for a Manchester code;

Figure 2 is a schematic diagram of a general example of a Manchester code demodulator;

Figure 3a is a schematic diagram of a first example implementation of a Manchester code demodulator;

Figure 3b is a schematic diagram of a second example implementation of a Manchester code demodulator;

Figure 4 is a schematic diagram of an example switched capacitor circuit;

Figure 5 is a schematic diagram of a combined mixer and filter circuit comprising the switched capacitor circuit of Figure 4;

Figure 6a is a schematic diagram of an example switched capacitor filter circuit;

Figure 6b is a schematic plot of example switching signals for operating the filter circuit of Figure 6a;

Figure 7 is a schematic diagram of a differential input signal implementation of the filter circuit of Figure 6a;

Figure 8 is a schematic diagram of an example switched capacitor filter circuit;

Figure 9 is a schematic diagram of an alternative representation of the switched capacitor filter circuit of Figure 8;

Figure 10 is a schematic diagram of an example Manchester code demodulator incorporating a plurality of filter circuits;

Figure 11 is a schematic diagram of the swap modules of the Manchester code demodulator of Figure 10.

It should be noted that the Figures are diagrammatic and not drawn to scale. Relative dimensions and proportions of parts of these Figures have been shown exaggerated or reduced in size, for the sake of clarity and convenience in the drawings. The same reference signs are generally used to refer to corresponding or similar features in modified and different embodiments.

Detailed description of embodiments

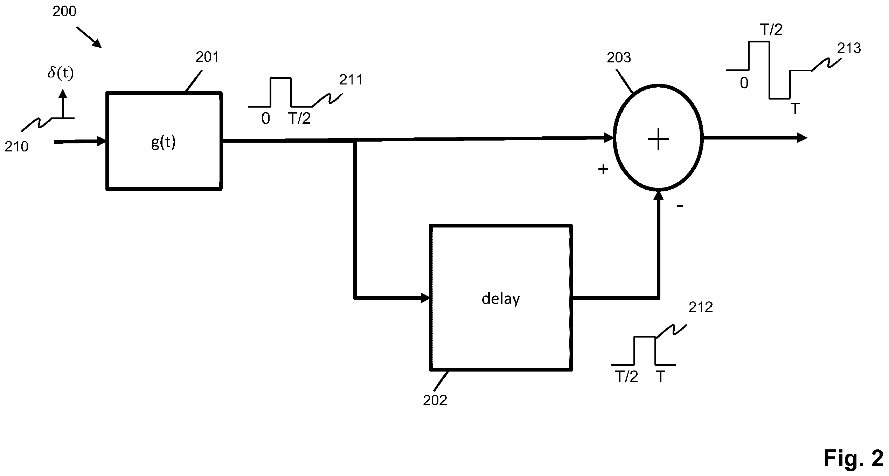

Figure 2 is a schematic diagram of an example Manchester code demodulator or decoder 200. The Manchester code demodulator comprises a filter g(t) 201, a delay function 202 and a subtract function, or subtractor, 203. The filter 201 converts an input signal 210 into a filtered signal 211. The filter 201 has an impulse response of a brick wall with a width of T/2, where T is the clock period of the Manchester encoding scheme utilised. The delay function 202 receives the filtered signal 211 and provides a delayed signal 212. The delayed signal 212 is delayed by a time T/2 relative to the filtered signal 211. The subtract function 203 receives the filtered signal 211 and the delayed signal 212 and provides an output signal 213 equal to the filtered signal 211 minus the delayed signal 212. The output signal 213 possesses the desired matched filter impulse response for a Manchester coded input signal. Depending on whether the output signal is encoded according to the G.E Thomas standard or the IEEE 802.3 standard, the output signal 213 may represent a Manchester coded zero or one. In either case, the output signal represents the original encoded bitstream (or its inverse).

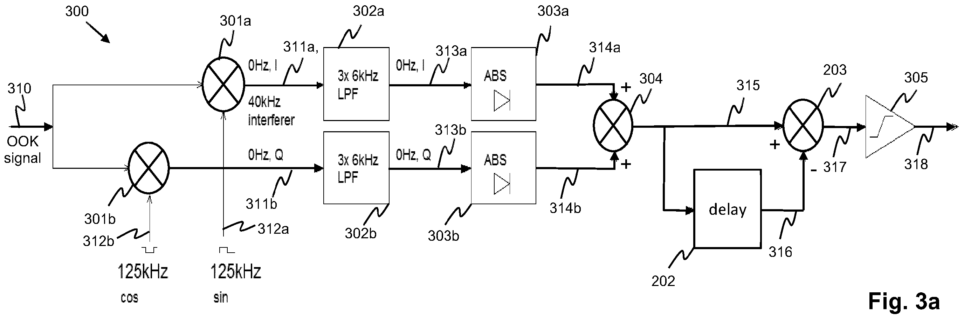

Figure 3a is a schematic diagram of an example implementation of a Manchester code demodulator 300. The demodulator 300 comprises the delay function 202 and subtract function 203 of Figure 2. The demodulator 300 comprises first and second mixers 301a, 301b, first and second low pass filters 302a, 302b, first and second absolute functions 303a, 303b and a summing function 304. The first and second mixers 301a, 301b receive an input signal 310 and extract I and Q (in-phase and quadrature) components 311a, 311b of the input signal. In this particular example, the input signal 310 is amplitude modulated using on-off keying (OOK) on a 125 kHz carrier signal with 85kHz added noise. The first and second mixers 301a, 301b are provided with first and second local oscillator signals 312a, 312b. First and second local oscillator signals are identical in frequency with a relative phase difference of 90°. In this example, the first mixer 301a is provided with the first local oscillator signal 312a in the form of a 125 kHz sine square wave and the second mixer 301b is provided with the second local oscillator signal 312b in the form of a 125 kHz cosine square wave. First and second mixers 301a, 301b together form a quadrature mixer configured to extract encoded I and Q signals 311a, 311b. In this example, the 85 kHz added noise is down-mixed to 40 kHz by the first and second mixers 301a, 301b.

The first and second low pass filters 302a, 302b receive the respective I and Q signals 311a, 311b and provide respective filtered I and Q signals 313a, 313b. In this example, the first and second filters 302a, 302b each comprise a three-pole low pass filter with a cut-off frequency of 6 kHz. The first and second filters 302a, 302b thereby remove or reduce noise above their cut-off frequency. In this example, the 40 kHz down-mixed noise is reduced by the first and second filters 302a, 302b.

The first and second absolute functions 303a, 303b receive the filtered I and Q signals 313a, 313b and output absolute values of the I and Q filtered signals 313a, 313b. The summing function 304 receives the I and Q magnitude signals 314a, 314b and provides a summed signal 315.

Similarly to Figure 2, the delay function 202 receives the summed signal 315 and outputs a delayed signal 316, delayed by a time T/2 relative to the summed signal 315. The subtractor 203 receives the summed signal 315 and the delayed signal 316 and provides an output signal 317. The output signal 317 equals the summed signal 315 minus the delayed signal 316. The comparator 305 receives the output signal 317 and outputs a corrected output signal 318. The corrected output signal 318 represents the original Manchester encoded bitstream (or its inverse). The comparator 305 may be implemented as an auto-zero comparator that periodically samples its offset and uses this offset measurement to self-correct.

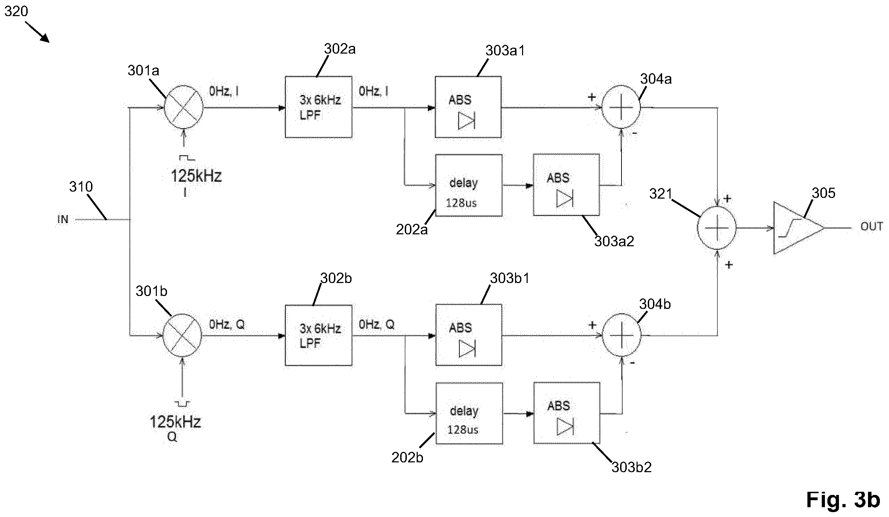

Figure 3b illustrates an alternative example implementation of a Manchester code demodulator 320, in which the delay module is instead provided as delay modules 202a, 202b in each of the Q and I branches prior to absolute functions 303a1, 303a2, 303b1, 303b2, following which summing functions 304a, 304b are provided in each branch and the resulting sums are provided to an output summing function 321 before the output comparator 305. The other components such as the mixers 301a, 301b and LPFs 302a, 302b are similar to those in Figure 3a.

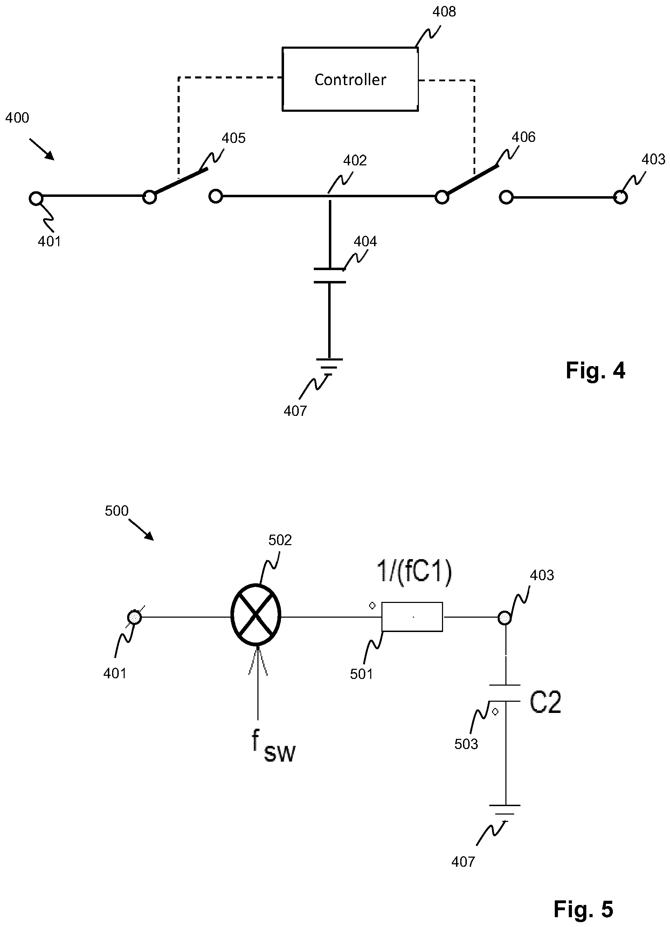

Figure 4 is a schematic diagram of an example switched capacitor circuit 400. The switched capacitor circuit 400 comprises a first node 401, a second node 402, a third node 403, a capacitor 404, a first switch 405, a second switch 406, a common connection 407 and a controller 408. The first switch 405 is connected between the first node 401 and the second node 402. The second switch 406 is connected between the second node 402 and the third node 403. The capacitor 404 is connected between the second node 402 and a common connection 407 (e.g. ground). A potential difference $V_1$ is between the first node 401 and the common connection 407 and a potential difference of $V_2$ is between the third node 403 and the common connection 407.

The controller 408 provides switching signals to the first and second switches 405, 406. The switching signals are non-overlapping square waves with an identical pulse width and period. The first and second switches 405, 406 close on a rising edge of a switching signal and open on a falling edge of the switching signal. In the case of the switched capacitor circuit 400, the desired switching cycle is defined by closing the first switch 405 and opening the second switch 406 in a first phase, followed in a second phase by opening the first switch 405 and closing the second switch 406. The controller 408 thereby provides a first switching signal to the first switch 405 and a second switching signal to the second switch 406, the second switching signal being non-overlapping and 180° out of phase with respect to the first switching signal.

Over each switching cycle, the charge $\Delta Q$ transported between the first node 401 and the second node 402 is given by $\Delta Q = C_1 (V_1 - V_2) = C_1.\Delta V$, where $C_1$ is the capacitance of the capacitor 404. This results in an average current of $I_{AV} = fsw .\Delta Q = f_{SW}C_1\Delta V$ where fsw is the switching frequency associated with the time taken for one switching cycle. This average current $I_{AV}$ can be used to determined an approximate resistance R using Ohm's law: $R = \Delta V / I_{AV} = 1 / (f_{SW}C_1)$. This relationship applies for input signal frequencies that are much less than the switching frequency fsw.

Figure 5 illustrates a switched capacitor circuit 500 including an alternative representation of the switched capacitor circuit 400 of Figure 4, in which the capacitor 404, first switch 405 and second switch 406 are represented by a resistor 501 and mixer 502. The switched capacitor circuit 500 further comprises a second capacitor 503, which is connected between the third node 403 and the common connection 407. When taking the third node 403 as an output connection, the resistor 501 and second capacitor 503 form a first order lowpass filter with a cutoff frequency of $1/RC_2 = (f_{SW}.C_1)/C_2$ (where $C_1$ is the capacitance of the first capacitor 404 and $C_2$ is the capacitance of the second capacitor 503). Operating the first and second switches 405, 406 according to the switching cycle mentioned above provides the action of a mixer 502 with a local oscillator frequency fsw.

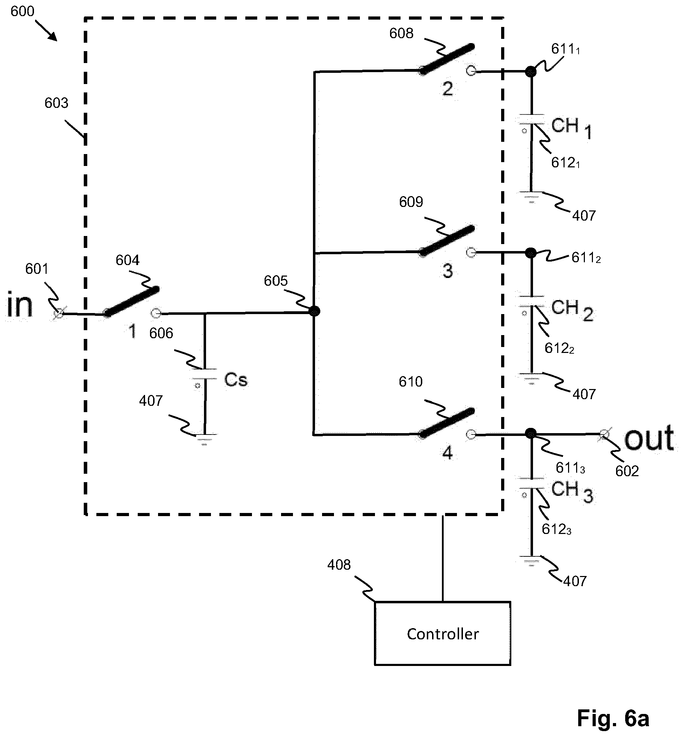

Figure 6a is a schematic diagram of an example circuit 600 using the principles outlined above for Figures 4 and 5 to provide an implementation of a combined mixer and filter circuit. The circuit 600 comprises an input connection 601, an output connection 602 and first, second and third filter capacitors $612_{1-3}$. The circuit 600 further comprises a switched capacitor circuit 603 comprising a first sampling switch 604, a first sampling capacitor 606 and first, second and third filter switches 608, 609, 610. The first sampling switch 604 is connected between the input connection 601 and a first node 605. The first sampling capacitor 606 is connected between the first node 605 and a common connection 407 (e.g. ground). The first filter switch 608 is connected between the first node 605 and a second node $611_1$. The second filter switch 609 is connected between the first node 605 and a third node $611_2$. The third filter switch 610 is connected between the first node 605 and a fourth node $611_3$.

The first filter capacitor $612_1$ is connected between the second node $611_1$ and the common connection 407. The second filter capacitor $612_2$ is connected between the third node $611_2$ and the common connection 407. The third filter capacitor 612s is connected between the fourth node 611s and the common connection 407. The filter circuit 600 implements a three-pole filter using the first, second and third filter capacitors $612_{1-3}$. In alternative examples the filter circuit 600 may implement a one or two pole filter using one or two filter capacitors together with corresponding filter switches. In other alternative examples the filter circuit 600 may implement a higher order filter with more than three filter capacitors together with corresponding filter switches. In a general aspect therefore, the filter circuit comprises at least a first filter switch and a first filter capacitor.

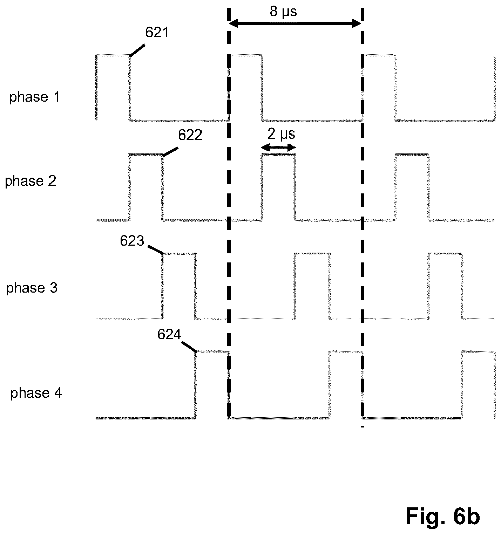

The controller 408 is configured to provide switching signals to switched capacitor circuit 603 to control switching of the first sampling switch 604 and each of the first, second and third filter switches 608-610 in a similar manner to that of the switched capacitor circuit 400 described above. For the three-pole filter circuit of Figure 6a, an example sequence of switching signals 621-624 is illustrated in Figure 6b. Each switching cycle is defined by four phases. In a first phase, the first sampling switch 604 is closed and all remaining switches 608-610 are open. In a second phase, the first filter switch 608 is closed and all remaining switches 604, 609, 610 are open. In a third phase, the second filter switch 609 is closed and all remaining switches 604, 608, 610 are open. In a fourth phase, the third filter switch 610 is closed and all remaining switches 604, 608, 609 are open. In a general aspect, the controller 408 is configured to provide switching signals 621-624 to each of the sampling and filter switches 604, 608, 609, 610 at a switching frequency. The switching signals 621-624 are non-overlapping. Each switching signal 621-624 has a duty cycle equal to, or smaller than, the inverse of the number of phases. For a single pole filter with one filter capacitor and filter switch, the duty cycle is 1/2 or less. For a two-pole filter with two filter capacitors and filter switches, the duty cycle is 1/3 or less. For a three-pole filter, i.e. the example in Figures 6a and 6b, the duty cycle is 1/4 or less. The maximum on period for each of the switching signals 621-624 is therefore equal to the switching period T (i.e. $1/f_{SW}$) divided by the number of phases. The on period can be less than this but needs to be sufficiently long to allow for charge to be redistributed before the switching period ends.

During the first phase, the input signal 601 is provided to the first sampling capacitor 606. In the second phase, the first sampling capacitor 606 is connected to the first filter capacitor $611_1$. This allows the charge associated with the input signal to be redistributed between the sampling capacitor 606 and the first filter capacitor $612_1$. Similarly, in the third phase, the first sampling capacitor 606 is connected to the second filter capacitor $612_2$, and in the fourth phase the first sampling capacitor 606 is connected to the third filter capacitor 612s.

Using the controller 408 to implement the above-described switching cycle creates the action of a mixer with a local oscillator frequency fsw. In the case of the filter circuit 600, the first, second and third filter capacitors $612_{1-3}$ with respective filter switches 608, 609, 610 form a third order low pass filter. The poles of this low pass filter have respective cut-off frequencies 1/RC of $(f_{SW}.C_s)/C_{H1}$, $(f_{SW}.C_s)/C_{H2}$ and $(f_{SW}.C_s)/C_{H3}$, where $C_s$ is the capacitance of the first sampling capacitor 606 and $C_{H1-H3}$ are the capacitances of the first, second and third filter capacitors $612_{1-3}$ respectively.

The switching frequency $f_{sw}$ may be chosen to correspond to a carrier frequency. For example, if the input signal is amplitude modulated on a carrier frequency of 125 kHz, the switching frequency $f_{sw}$ may be chosen such that the phases each last 2 $\mu$s to give a total switching period of 8 $\mu$s, as illustrated in the example of Figure 6b.

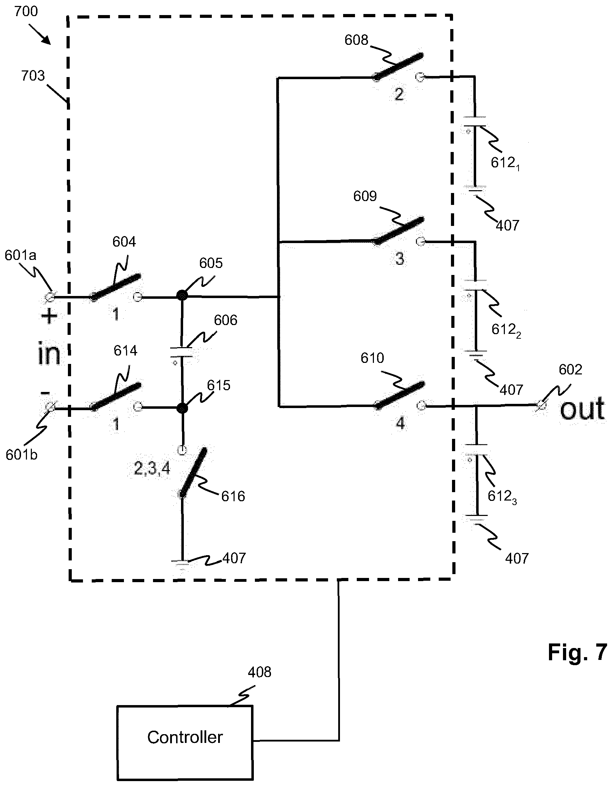

Figure 7 is a schematic diagram of a filter circuit 700 similar to the filter circuit 600 of Figure 6a but with a differential input. Instead of a single input connection, the filter circuit 700 comprises first and second input connections 601a, 601b for receiving a differential input signal. The switched capacitor circuit 703 comprises second and third sampling switches 614, 616. The second sampling switch 614 is connected between the second input connection 601b and a fifth node 615. The third sampling switch 616 is connected between the fifth node 615 and the common connection 407. The first sampling capacitor 606 is connected between the first node 605 and the fifth node 615. As with the filter circuit 600 of Figure 6a, the filter circuit 700 may comprise at least a first filter switch and a first filter capacitor.

The controller 408 is configured to provide switching signals to the switched capacitor circuit 703 similarly to that of the filter circuit 600 of Figure 6a, with switching signals provided to the first and second sampling switches 604, 614 being provided synchronously and switching signals provided to the third sampling switch 616 while any of the filter switches 608, 609, 610 are switched. Switching signals provided to the second and third sampling switches 614, 616 modify the switching cycle outlined in relation to the filter circuit 600. During the first phase (Figure 6b), a differential input signal is received at the first and second input connections 601a, 601b and provided across the first sampling capacitor 606 by closing the first and second sampling switches 604, 614. During subsequent phases, the third sampling switch 616 remains closed. This allows the first sampling capacitor 606 to be connected between the first node 605 and the common connection 407 in a similar manner to that of the filter circuit 600.

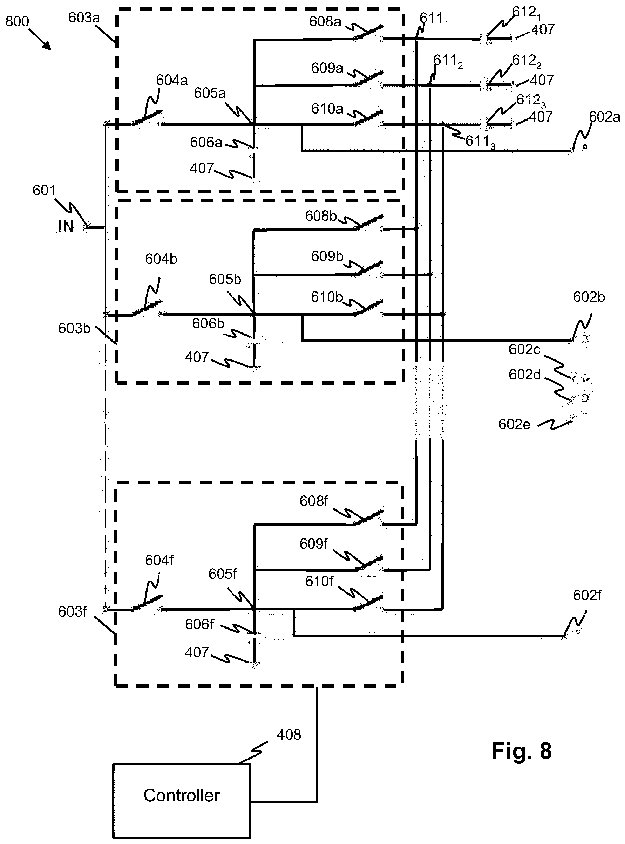

Figure 8 is a schematic diagram of an example filter circuit 800. The filter circuit 800 comprises an input connection 601, a plurality of output connections 602a-f, a plurality of switched capacitor circuits 603a-f and a controller 408. Similar to the filter circuit 600, each of the switched capacitor circuits 603a-f comprises a first sampling switch 604a-f, a first sampling capacitor 606a-f, and first, second, and third filter switches 608a-f, 609a-f, 610a-f. The first sampling switch 604a-f of each switched capacitor circuit 603a-f is connected between the input connection 601 and a first node 605a-f. The first sampling capacitor 606a-f is connected between the first node 605a-f and a common connection 407. The first filter switch 608a-f is connected between the first node 605a-f and a second node $611_1$. The second filter switch 609a-f is connected between the first node (605a-f) and a third node $611_2$. The third filter switch 610a-f is connected between the first node 605a-f and a fourth node $611_3$. The filter circuit 800 further comprises first, second and third filter capacitors $612_{1-3}$. The first filter capacitor $612_1$ is connected between the second node $611_1$ and the common connection 407. The second filter capacitor $612_2$ is connected between the third node $611_2$ and the common connection 407. The third filter capacitor 612s is connected between the fourth node 611s and the common connection 407. In a general aspect, the filter circuit comprises at least a first filter switch and a first filter capacitor. The illustrated example shows a three-pole filter implementation. Other filter implementations may include at least one pole, i.e. with at least one filter switch and filter capacitor in each switched capacitor circuit.

Each of the plurality of output connections 602a-f is connected to a respective first node 605a-f of a respective one of the switched capacitor circuits 603a-f. With appropriately timed switching signals provided by the controller 408, the output connections 602a-f provide output signals with varying delays, which can be combined in various combinations to provide a Manchester code demodulator.

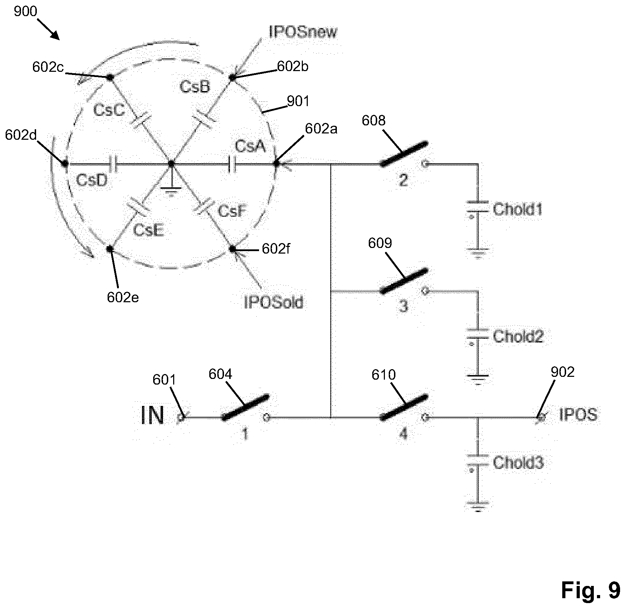

Figure 9 is a schematic diagram of a filter circuit 900 that is a functionally equivalent representation of the filter circuit 800, in which the sampling capacitors 606a-f, shown here as capacitors CsA-F, are represented as a rotating carousel 901. The filter capacitors $612_{1-3}$ are represented as capacitors Chold1-3. Switches 604, 608, 609, 610 represent switches 604a-f, 608a-f, 609a-f, 610a-f of Figure 8. During operation, a filtered signal is present at node 902 between switch 610 and capacitor Chold3. This filtered signal is refreshed each time switch 610 is operated. The value at that moment is also present at the 'wiper node' 602a of the carousel 901. The carousel 901 then shifts one position counter clockwise, the sample remains stored and a new sample capacitor Csx is used for the next filter action. The result of this is that the outputs 602a-f shown in Figure 8 correspond to the nodes 602a-f of the carousel 901. A single switching cycle of the circuit 900 may be defined as the time taken for the four phases to complete, with the first phase closing switch 604, the second phase closing switch 608, the third phase closing switch 609 and the fourth phase closing switch 610. For a 125 kHz switching frequency, each phase lasts 2 $\mu$s, with a total time taken of 8 $\mu$s for the single switching cycle. The carousel 901 rotates one position anti-clockwise every four switching cycles, resulting in a total delay between signals IPOSnew and IPOSold of 128 $\mu$s, which changes every 32 $\mu$s for a 125 kHz switching frequency.

Combining four of the above-described circuits 800, 900 enables four output signals, together with their delayed versions, to be generated, representing positive and negative in-phase (I) and quadrature (Q) signals IPOS, INEG, QPOS, QNEG. These signals may be differential signals in example implementations, but are represented here for simplicity as single-ended signals.

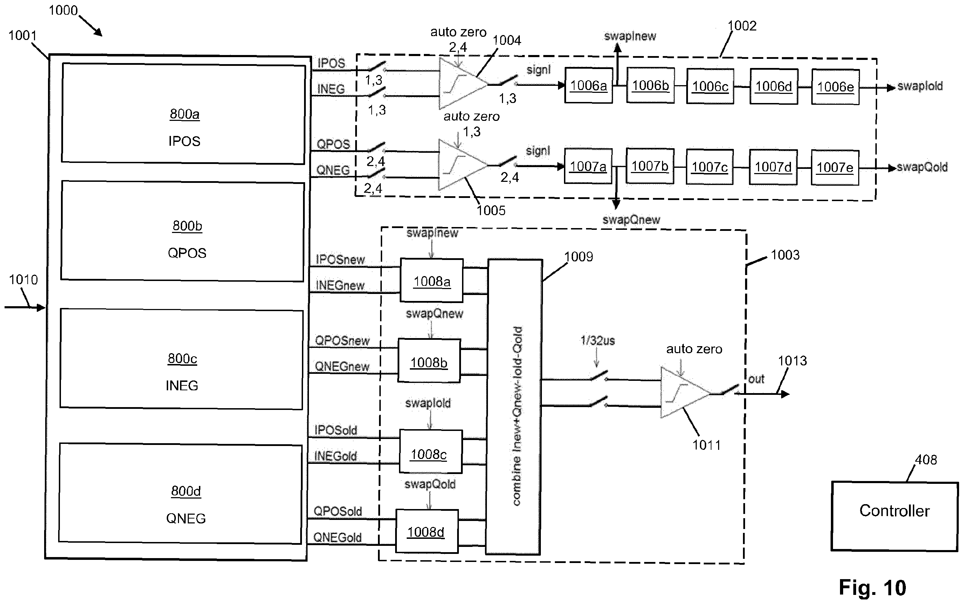

Figure 10 is a schematic diagram of an example Manchester code demodulator 1000, in which a plurality of filter circuits of the type described above are used to provide mixing and filtering functions and some of the delay function corresponding to the Manchester decoders 300, 320 of Figures 3a and 3b described above. The mixing and filtering functions are provided in this example by a filter module 1001 comprising four filter circuits 800a-d, each of which may be a filter circuit according to the filter circuits 800, 900 described above. The filter module 1001 provides IPOS, INEG, QPOS and QNEG output signals, together with current and delayed versions of these signals, IPOSnew, IPOSold, QPOSnew, QPOSold, INEGnew, INEGold, QNGnew, QNEGold.

In the example decoded 1000 in Figure 10, the filter module outputs six differential I and Q signals, being:

| | |
|---|---|
| 'I': IPOS - INEG: | the actual differential I-output; |
| 'Q': QPOS - QNEG: | the actual differential Q-output; |
| 'Inew': IPOSnew - INEGnew: | the most recently stored differential-I sample; |
| 'Qnew': QPOSnew-QNEGnew: | the most recently stored differential Q-sample; |
| 'Iold':IPOSold - INEGold: | the oldest stored differential I-sample; and |
| 'Qold': QPOSold - QPOSold: | the oldest stored differential Q-sample |

The IPOS - INEG, QPOS - QNEG ('I' and 'Q') differential signals are used to determine the sign of the signal in the delay module 1002. This is needed to generate the absolute value of each signal. If the sign of the actual I and Q-signal is known, the sign of the 'new' samples and the 'old' samples can easily be derived by delaying these (digital) sign signals by 1, respectively 5, clock periods of a 125kHz/4 clock ($32\mu$s period) with delay functions 1006a-e, 1007a-e. These sign signals are used to swap (or not swap) the Inew, Iold, Qnew and Qold differential signals. After this operation, four differential rectified signals are provided:

| | |
|---|---|
| 'Irectnew': | abs(IPOSnew - INEGnew) or IPOSRECTnew - INEGRECTnew |
| 'Qrectnew': | abs(QPOSnew - QNEGnew) or QPOSRECTnew - QNEGRECTnew |
| 'Irectold': | abs(IPOSold - INEGold) or IPOSRECTold - INEGRECTold |
| 'Qrectold': | abs(QPOSold - QNEGold) or QPOSRECTold - QNEGRECTold |

These signals are then combined by the combining function 1009, i.e.:

$$Irectnew + Qrectnew - Irectold - Qrectold$$

The output of the combining function 1009 is then provided to an output comparator 1011, which provides the output decoded signal 1013.

A controller 408 provides switching signals to the filter module 1001 to provide switching signals to each of the sampling switches and filter switches at a switching frequency, as described above.

The controller 408 provides a switching signal to the first sampling switch 604a-f of one of the switched capacitor circuits 603a-f of each of the filter circuits 800a-d to connect the input signal 1010 to the sampling capacitor 606a-f during each switching cycle. In a subsequent switching cycle the controller provides a switching signal to the first sampling switch 604a-f of another one of the switched capacitor circuits 603a-f. Over successive switching cycles the switching signals are provided to successive ones of the switched capacitor circuits 603a-f, thereby providing delayed versions of the output signals. The output signals IPOS, INEG, QPOS, QNEG from the filter module 1001 are provided to the delay module 1002, which compares the output signals and provides swap signals swapInew, swapQnew, swapIold, swapQold to the subtractor module 1003. The subtractor module 1003 receives the current and delayed versions of these signals, IPOSnew, IPOSold, QPOSnew, QPOSold, INEGnew, INEGold, QNGnew, QNEGold and combines these, using the swap signals from the delay module 1002, to provide an output signal 1013. Swap modules 1008a-d receive the swap signals swapInew, swapQnew, swapIold, swapQold from the delay module 1002 and swap pairs of current and delayed signals according to the swap signals before providing the current and delayed signals to a combining function 1009, which combines the current and delayed signals and provides an output to an output comparator 1011. The output comparator 1011 provides the output decoded signal 1013.

The absolute function of the Manchester code demodulator 1000 is performed by swapping or not swapping the 'old' and 'new' signals IPOSnew, IPOSold, QPOSnew, QPOSold, INEGnew, INEGold, QNEGnew, QNEGold depending on the sign of the actual output signals IPOS, INEG, QPOS, QNEG.

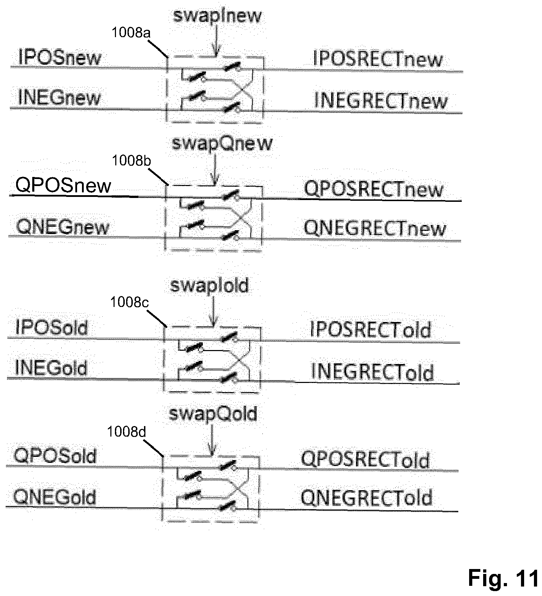

Figure 11 illustrates a more detailed view of the swap modules 1008a-d from Figure 10, showing how each swap module 1008a-d is configured to selectively switch input signals IPOSnew, INEGnew, QPOSnew, QNGnew, IPOSold, INEGold, QPOSold, QNEGold according to a received swap signal swapInew, swapQnew, swapIold, swapQold, thereby providing respective rectified signals IPOSRECTnew, QPOSRECTnew, QPOSRECTnew, QNEGRECTnew, IPOSRECTold, INEGRECTold, QPOSRECTold, QNEGRECTold to the combining function 1009.

The sign of the signal provided by the combining function 1009 is derived from an output comparator 1011 at the output of the subtractor module 1003, which in this example is delayed by one or 5 clock cycles of 32 $\mu$s. The last combination (adding or subtracting rectified 'old' and 'new' signals) can be done using multiple input stages in parallel in the output slicer / comparator.

In the Manchester code demodulator 1000 illustrated in Figure 10, switching signals provided by the controller 408 to control inputs to the delay module 1002 are indicated such that in-phase signals IPOS, INEG are provided to a first delay module comparator 1004 during first and third phases of each switching cycle and quadrature signals QPOS, QNEG are provided to a second delay module comparator 1005 during second and fourth phases of each cycle. Each comparator 1004, 1005 auto-zeros during other phases of each switching cycle, i.e. the first comparator 1004 auto-zeros during the second and fourth phases and the second comparator 1005 auto-zeros during the first and third phases. The comparators 1004, 1005 provide output signals to first and second series of delay functions 1006a-e, 1007a-e. A first delay function 1006a, 1007a of each of the series of delay functions receives the output signal from a respective one of the comparators 1004, 1005 and provides first swap signals swapInew, swapQnew to the first and second swap modules 1008a, 1008b of the subtractor module 1003. Second, third, fourth and fifth delay functions 1006b-e, 1007b-e of each of the series of delay functions further delay the first swap signals swapInew, swapQnew and provide second swap signals swapIold, swapQold to the third and fourth swap modules 1008c, 1008d.

An advantage of the filter circuit and Manchester code demodulator described herein relates to the need for fewer active components, which is achieved by way of a combined filter and delay module using switches and capacitors, enabling a programmable delay function at the filter outputs without the need for active components.

From reading the present disclosure, other variations and modifications will be apparent to the skilled person. Such variations and modifications may involve equivalent and other features which are already known in the art of switched capacitor circuits and Manchester code demodulators, and which may be used instead of, or in addition to, features already described herein.

Although the appended claims are directed to particular combinations of features, it should be understood that the scope of the disclosure of the present invention also includes any novel feature or any novel combination of features disclosed herein either explicitly or implicitly or any generalisation thereof, whether or not it relates to the same invention as presently claimed in any claim and whether or not it mitigates any or all of the same technical problems as does the present invention.

Features which are described in the context of separate embodiments may also be provided in combination in a single embodiment. Conversely, various features which are, for brevity, described in the context of a single embodiment, may also be provided separately or in any suitable sub-combination. The applicant hereby gives notice that new claims may be formulated to such features and/or combinations of such features during the prosecution of the present application or of any further application derived therefrom.

For the sake of completeness it is also stated that the term "comprising" does not exclude other elements or steps, the term "a" or "an" does not exclude a plurality, a single processor or other unit may fulfil the functions of several means recited in the claims and reference signs in the claims shall not be construed as limiting the scope of the claims.

**Claims**

1. A filter circuit (800) comprising:

> an input connection (601);
> a plurality of output connections (602a-f); and
> a plurality of switched capacitor circuits (603a-f), each switched capacitor circuit (603a-f) comprising:

>> a first sampling switch (604a-f) connected between the input connection (601) and a first node (605a-f);
>> a sampling capacitor (606a-f) connected between the first node (605a-f) and a common connection (407); and
>> a first filter switch (608a-f) connected between the first node (605a-f) and a second node ($611_1$),

> the circuit (800) further comprising a first filter capacitor ($612_1$) connected between the second node ($611_1$) of each of the switched capacitor circuits (603a-f) and the common connection (407).

2. The filter circuit (800) of claim 1, wherein each switched capacitor circuit (603a-f) further comprises a second filter switch (609a-f) connected between the first node (605a-f) and a third node ($611_2$), the circuit further comprising a second filter capacitor ($612_2$) connected between the third node ($611_2$) and the common connection (407).

3. The filter circuit (800) of claim 2, wherein each switched capacitor circuit (603a-f) further comprises a third filter switch (610a-f) connected between the first node (605a-f) and a fourth node (611s), the circuit (800) further comprising a third filter capacitor (612s) connected between the fourth node (611s) and the common connection (407).

4. The filter circuit of any preceding claim, wherein the input connection is a first input connection, the circuit further comprising a second input connection (601b), each switched capacitor circuit (603a-f) comprising:

   a second sampling switch (614a) connected between the second input connection (601b) and a fifth node (615); and
   a third sampling switch (616) connected between the fifth node (615) and the common connection (407), the first sampling capacitor (606, 606a-f) connected between the first node (605) and the fifth node (615) for receiving a differential input signal via the first and second sampling switches (604, 614).

5. The filter circuit (800) of any preceding claim, further comprising a controller (408) configured to provide switching signals (621-624) to each of the sampling switches (604a-f, 614a, 616a) and filter switches (608a-f, 609a-f, 610a-f) at a switching frequency.

6. A Manchester code demodulator (200, 900) comprising:

   a filter module (201, 1001) configured to receive an input coded signal (210, 1010) and provide a filtered signal (211);
   a delay module (202, 1002) configured to receive the filtered signal (211) from the filter module (201) and output a delayed signal (212);
   a subtractor module (203, 1003) configured to receive the filtered signal (211) from the filter module (201, 901) and the delayed signal (212) from the delay module (202, 902) and to provide an output decoded signal (213, 1013) by subtracting the delayed signal (212) from the filtered signal (211),
   wherein the filter module (201) comprises a plurality of filter circuits (800a-d) according to any one of claims 1 to 4, the input connection (601) of each filter circuit (800a-d) configured to receive the input coded signal (210, 901).

7. The Manchester code demodulator (200, 900) of claim 6, further comprising a controller (408) configured to provide switching signals (621-624) to each of the sampling switches (604a-f, 614a, 616a) and filter switches (608a-f, 609a-f, 610a-f) of the plurality of filter circuits at a switching frequency (fsw).

8. The Manchester code demodulator (1000) of claim 7, wherein the controller (408) is configured to provide a switching signal to the first sampling switch (604a-f) of one of the switched capacitor circuits (603a-f) of each of the filter circuits (800a-d) to connect the input signal (1010) to the sampling capacitor (606a-f) during a switching cycle.

9. The Manchester code demodulator (1000) of claim 8, wherein the controller (408) is configured, in a subsequent switching cycle, to provide a switching signal to the first sampling switch of another one of the switched capacitor circuits (603a-f).

10. The Manchester code demodulator (1000) of any one of claims 7 to 9, wherein the filter module (1001) is configured, under control of the switching signals provided by the controller (408), to provide in-phase, I, and quadrature, Q, output signals (IPOS, INEG, QPOS, QNEG) to the delay module (1002).

11. The Manchester code demodulator (1000) of claim 10, wherein the filter module (1001) is configured, under control of the switching signals provided by the controller (408), to provide current and delayed I and Q output signals (IPOSnew, INEGnew, QPOSnew, QNEGnew, IPOSold, INEGold, QPOSold, QNEGold) to the subtractor module (1003).

12. The Manchester code demodulator of claim 11, wherein the delay module (1002) is configured to generate current and delayed swap signals (swapInew, swapQnew, swapIold, swapQold) from signs of the current I and Q signals (IPOS, INEG, QPOS, QNEG).

**13.** The Manchester code demodulator (1000) of claim 12, wherein the subtractor module (1003) comprises a plurality of swap modules (1008a-d) arranged to swap I and Q signals output from the filter module (1001) under control of the current and delayed swap signals (swapInew, swapQnew, swapIold, swapQold) generated by the delay module (1002).

**14.** The Manchester code demodulator (1000) of claim 13, wherein the subtractor module (1003) comprises a combining function (1009) arranged to combine I and Q signals output by the swap modules (1008a-d) to provide a combined output signal.

**15.** The Manchester code demodulator (1000) of claim 14, wherein the subtractor module (1003) comprises a comparator (1011) arranged to receive the combined output signal from the combining function (1009) and to provide the output decoded signal (1013).

Fig. 1

Fig. 2

Fig. 3a

Fig. 3b

**Fig. 4**

**Fig. 5**

Fig. 6a

Fig. 6b

Fig. 7

**Fig. 8**

Fig. 9

Fig. 10

**Fig. 11**

Europäisches
Patentamt

European
Patent Office

Office européen
des brevets

# EUROPEAN SEARCH REPORT

Application Number

EP 23 16 2097

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 1 319 267 B1 (KABEN RES INC [CA]) 7 November 2012 (2012-11-07) | 1-5 | INV. H04L25/49 |
| Y | * paragraph [0084] – paragraph [0094] * * paragraph [0143] – paragraph [0148] * * figures 13A, 13B, 14, 26 * | 6-15 | H04L25/02 H03K9/08 H03K9/04 |
| X | US 7 834 797 B2 (SONY CORP [JP]) 16 November 2010 (2010-11-16) | 1-5 | |
| Y | * column 5, line 19 – line 39 * * figure 1 * | 6-15 | |
| Y | US 7 450 666 B2 (PANASONIC CORP [JP]) 11 November 2008 (2008-11-11) * column 10, line 63 – column 11, line 23 * * figure 1 * | 6-15 | |
| Y | EP 0 289 237 A2 (AMERICAN TELEPHONE & TELEGRAPH [US]) 2 November 1988 (1988-11-02) * figure 1 * | 6-15 | |

TECHNICAL FIELDS
SEARCHED      (IPC)

H04L
H03K

The present search report has been drawn up for all claims

| Place of search | Date of completion of the search | Examiner |
|---|---|---|
| Munich | 8 August 2023 | Schiffer, Andrea |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons
...................................................................................................
& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 23 16 2097

This annex lists the patent family members relating to the patent documents cited in the above-mentioned European search report.
The members are as contained in the European Patent Office EDP file on
The European Patent Office is in no way liable for these particulars which are merely given for the purpose of information.

08-08-2023

| Patent document cited in search report | | | Publication date | Patent family member(s) | | | Publication date |
|---|---|---|---|---|---|---|---|
| EP 1319267 | B1 | | 07-11-2012 | AU | 9356001 | A | 02-04-2002 |
| | | | | CA | 2422794 | A1 | 28-03-2002 |
| | | | | CN | 1459143 | A | 26-11-2003 |
| | | | | EP | 1319267 | A2 | 18-06-2003 |
| | | | | HK | 1059990 | A1 | 23-07-2004 |
| | | | | WO | 0225803 | A2 | 28-03-2002 |
| US 7834797 | B2 | | 16-11-2010 | CN | 101447780 | A | 03-06-2009 |
| | | | | EP | 2066029 | A2 | 03-06-2009 |
| | | | | JP | 2009135595 | A | 18-06-2009 |
| | | | | KR | 20090055489 | A | 02-06-2009 |
| | | | | US | 2009135039 | A1 | 28-05-2009 |
| US 7450666 | B2 | | 11-11-2008 | AT | 476042 | T | 15-08-2010 |
| | | | | CN | 1630201 | A | 22-06-2005 |
| | | | | EP | 1528738 | A2 | 04-05-2005 |
| | | | | KR | 20050041950 | A | 04-05-2005 |
| | | | | US | 2005094745 | A1 | 05-05-2005 |
| EP 0289237 | A2 | | 02-11-1988 | EP | 0289237 | A2 | 02-11-1988 |
| | | | | JP | S6429120 | A | 31-01-1989 |
| | | | | KR | 880013339 | A | 30-11-1988 |
| | | | | US | 4881059 | A | 14-11-1989 |

EPO FORM P0459

For more details about this annex : see Official Journal of the European Patent Office, No. 12/82